# EUROPÄISCHE PATENTSCHRIFT

(11) **EP 1 665 324 B1**
(45) Veröffentlichungstag und Bekanntmachung des Hinweises auf die Patenterteilung: **24.01.2007**
(21) Anmeldenummer: 04786748.6
(22) Anmeldetag: 08.09.2004
(51) Int. Cl.: H01J 37/32

(54) **ECR-PLASMAQUELLE MIT LINEARER PLASMAAUSTRITTSÖFFNUNG**
ELECTRON CYCLOTRON RESONANCE (ECR) PLASMA SOURCE HAVING A LINEAR PLASMA DISCHARGE OPENING
SOURCE DE PLASMA ECR COMPRENANT UNE OUVERTURE DE SORTIE DE PLASMA LINEAIRE

(30) Priorität: 08.09.2003 DE 10341239
(43) Veröffentlichungstag der Anmeldung: 07.06.2006
(73) Patentinhaber: Roth & Rau AG, 09337 Hohenstein-Ernstthal (DE)
(72) Erfinder: MAI, Joachim, 04603 Nobitz (DE); ROTH, Dietmar, 09353 Oberlungwitz (DE)
(74) Vertreter: Pätzelt, Peter
(86) Internationale Anmeldenummer: PCT/DE2004/002027
(87) Internationale Veröffentlichungsnummer: WO 2005/027595

(56) Entgegenhaltungen:
- WO-A-00/75955
- DE-A1- 19 812 558
- US-A- 5 149 375
- US-A- 5 466 295
- US-A1- 2003 062 129
- PATENT ABSTRACTS OF JAPAN Bd. 012, Nr. 054 (E-583), 18. Februar 1988 (1988-02-18) & JP 62 200730 A (NIPPON TELEGR & TELEPH CORP <NTT>), 4. September 1987 (1987-09-04)

## Beschreibung

### Technisches Gebiet

Die Erfindung betrifft eine ECR-Plasmaquelle mit einer linearen Plasmaaustrittsöffnung an einer Plasmakammer, die gleichzeitig als Außenleiter wirkt und in der ein zentrischer Wellenverteiler vorhanden ist, welcher mit einer Einrichtung zur Erzeugung einer Hochfrequenz verbunden ist, sowie mit einer Multipol-Magnetfeldanordnung im Bereich der linearen Plasmaaustrittsöffnung. Als Hochfrequenz kommen alle technisch verwertbaren und zugelassenen Frequenzbereiche in Betracht. In der Praxis haben sich besonders Frequenzen zwischen 13,56 MHz und 2,45 GHz bewährt.

### Stand der Technik

Nach dem Stand der Technik sind vielfältige Plasmaerzeugungseinrichtungen bekannt. Die DE 198 12 558 A1 beschreibt eine Vorrichtung zur Erzeugung linear ausgedehnter ECR-Plasmen (Electron-Zyklotron-Resonanz-Plasmen). Ein Innenleiter ist mit einer Einrichtung zur Erzeugung von Mikrowellen (910 MHz bis 2,45 GHz) verbunden und koaxial in einem gut leitfähigen äußeren Koaxialwellenleiter angeordnet, der gleichzeitig den Plasmaraum begrenzt. Der rohrförmige Plasmaraum weist parallel zur Längsachse eine spaltförmige Öffnung auf, an der beidseitig zur Längsachse je eine Multipol-Magnetanordnung zur Erzeugung eines statischen Magnetfeldes vorgesehen ist. Werden über den Innenleiter (Wellenverteiler) Mikrowellen in den mit einem Trägergas gefluteten Plasmaraum eingespeist, bildet sich im Plasmaraum ein Plasma aus. Im Bereich der spaltförmigen Öffnung wird das Plasma durch das Magnetfeld der Multipol-Magnetanordnung mit starken elektrischen Feldkomponenten wesentlich verstärkt.

Mit einer derartigen Einrichtung kann sehr vorteilhaft ein linear ausgedehntes Plasma erzeugt werden. Nachteilig ist jedoch, dass die Plasmadichte in der Längsachse der spaltförmigen Öffnung relativ stark schwankt und quer zu Längsachse eine parabelförmige Ausdehnung mit einem relativ kleinem Scheitelkrümmungsradius aufweist.

### Darstellung der Erfindung

Der Erfindung liegt damit als Aufgabe zugrunde, eine lineare ECR-Plasmaquelle der eingangs genannten Art anzugeben, mit der an der Plasmaaustrittsöffnung ein großflächiges homogenes Plasma ausgebildet werden kann.

Die Erfindung löst die Aufgabe durch die im Anspruch 1 angegebenen Merkmale.

Vorteilhafte Weiterbildungen der Erfindung sind in den jeweiligen Unteransprüchen gekennzeichnet und werden nachstehend zusammen mit der Beschreibung der bevorzugten Ausführung der Erfindung, einschließlich der Zeichnung, näher dargestellt.

Der Kern der Erfindung besteht darin, dass mindestens zwei als solche bekannte lineare ECR-Plasmaquellen mit Wellenverteiler und Multipol-Magnetfeldanordnung in erfinderischer Weise zu einer leistungsfähigen linearen ECR-Plasmaquelle mit mindestens einer Plasmaaustrittsöffnung weiter entwickelt werden.

Für viele Anwendungsfälle wird eine ECR-Plasmaquelle mit zwei Teil-Plasmakammern ausreichend sein. Eine erfindungsgemäße ECR-Plasmaquelle kann jedoch, insbesondere abgestimmt auf die konkrete Form der Substrate oder Anordnung der Substrate auf Substratträgern, auch drei und mehr Teil-Plasmakammern aufweisen. In ähnlicher Weise kann die ECR-Plasmaquelle eine oder zwei Plasmaaustrittsöffnungen aufweisen und bei drei oder mehr Teil-Plasmakammern auch mehr Plasmaaustrittsöffnungen.

Nach den Ansprüchen 2 bis 4 kann die ECR-Plasmaquelle spezifische Plasmaaustrittsöffnungen aufweisen, die wesentlich von der Lage der eigentlichen plasmaerzeugenden Teil-Plasmakammern und ihrer Lage zueinander abhängig sind.

Nach Anspruch 6 kann die ECR-Plasmaquelle in vorteilhafter Weise derart weitergebildet werden, dass zusätzlich zu den Multipol-Magnetanordnungen im Bereich der Teil-Plasmaaustrittsöffnungen eine oder mehrere weitere Multipol-Magnetanordnungen außerhalb der Teil-Plasmakammern fest oder verschiebbar angeordnet sind. Damit kann die Plasmabildung im Inneren der Teil-Plasmakammern in spezifischer Weise beeinflusst werden.

Weitere vorteilhafte Ausbildungen sind in den nachfolgenden Ausführungsbeispielen näher beschrieben.

Der Vorteil der erfindungsgemäßen ECR-Plasmaquelle besteht insbesondere darin, dass durch Überlagerung von mindestens zwei einzelnen Plasmen ein dichtes und weitgehend homogenes Plasma erzeugt werden kann, mit dem in vorteilhafter Weise eine effektive Plasmabehandlung von großen Substraten oder Substratanordnungen durchgeführt werden kann.

Während nach dem Stand der Technik bei größeren linearen Plasmen, z.B. bei Schichtabscheidungen die Schichtdicken Inhomogenitäten über ± 8% aufweisen, konnten mit der erfindungsgemäßen ECR-Plasmaquelle Schichtdicken von Siliziumnitridschichten über eine Länge des Plasmaaustritts von ca. 800 mm mit Inhomogenitäten von weniger ± 2% hergestellt werden.

Dabei ist durch Variation der eingespeisten Wellenleistung, der Form der Teil-Plasmakammern, der Lage und Stärke der Magnetfelder der Multipol-Magnetfeldanordnung sowie einer variablen Gasführung eine praktisch sehr flexible Prozessführung möglich.

Die Erfindung wird nachstehend an vier Ausführungsbeispielen näher erläutert.

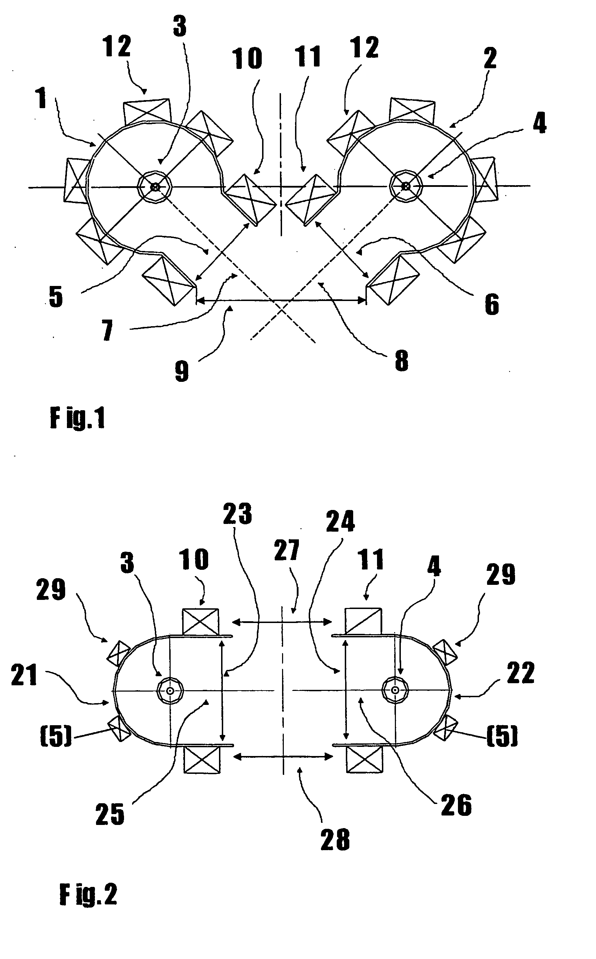

Zugehörig zu Aufführungsbeispiel I zeigt Figur 1 einen Schnitt durch eine schematische ECR-Plasmaquelle mit einer Plasmaaustrittsöffnung, bei der die radialen Linien zwischen jeweils dem einzelnen Wellenverteiler und der Breitenmitte der Teil-Plasmaaustrittsöffnung zueinander um einen Winkel von 90 Grad geneigt sind.

Zugehörig zu Aufführungsbeispiel II zeigt Figur 2 einen Schnitt durch eine schematische ECR-Plasmaquelle mit zwei Plasmaaustrittsöffnungen, bei der die radialen Linien zwischen jeweils dem einzelnen Wellenverteiler und der Breitenmitte der Teil-Plasmaaustrittsöffnung auf einer Achse liegen und zwei Plasmaaustrittsöffnungen der ECR-Plasmaquelle dazu rechtwinklig angeordnet sind.

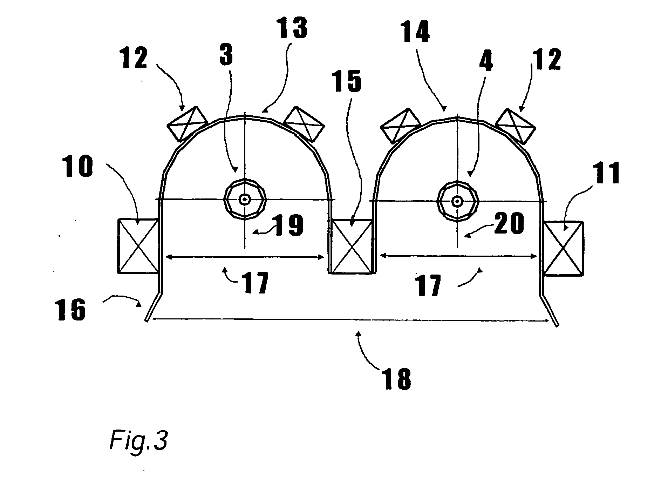

Zugehörig zu Aufführungsbeispiel III zeigt Figur 3 einen Schnitt durch eine schematische ECR-Plasmaquelle mit einer Plasmaaustrittsöffnung, bei der die radialen Linien zwischen jeweils dem einzelnen Wellenverteiler und der Breitenmitte der Teil-Plasmaaustrittsöffnung zueinander parallel angeordnet sind.

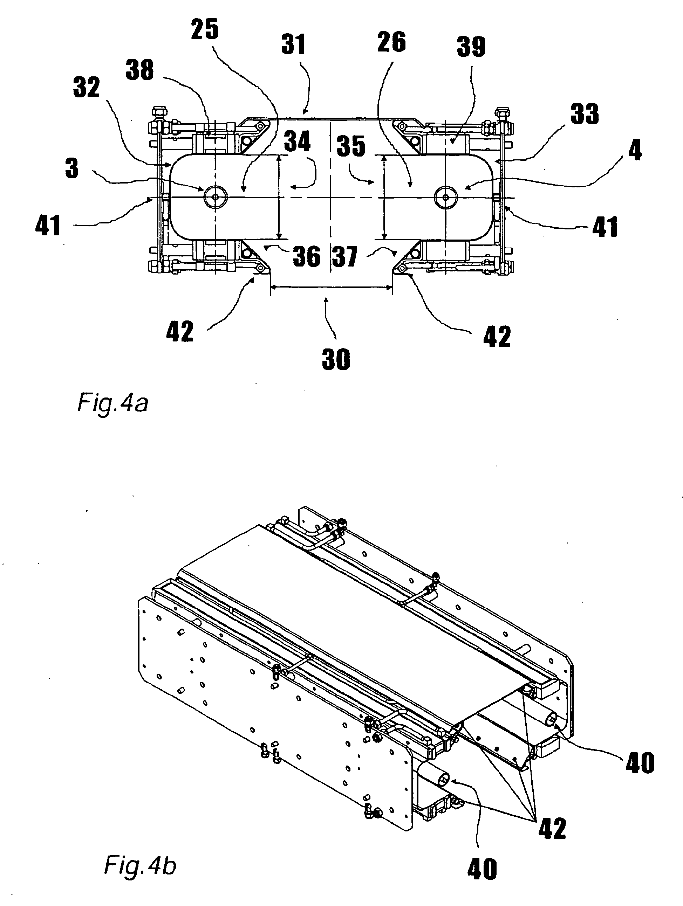

Zugehörig zu Aufführungsbeispiel IV zeigt Figur 4a einen Schnitt durch eine konstruktive Ausbildung einer ECR-Plasmaquelle mit einer Plasmaaustrittsöffnung, bei der die radialen Linien zwischen jeweils dem einzelnen Wellenverteiler und der Breitenmitte der Teil-Plasmaaustrittsöffnung auf einer Achse liegen und die Plasmaaustrittsöffnung der ECR-Plasmaquelle dazu rechtwinklig angeordnet ist. Figur 4b zeigt die ECR-Plasmaquelle nach Figur 4a in einer perspektivischen Ansicht.

### Ausführungsbeispiel I

Die erfindungsgemäße ECR-Plasmaquelle nach Ausführungsbeispiel I besteht im Wesentlichen aus zwei einzelnen ECR-Plasmaquellen. Figur 1 zeigt zwei Teil-Plasmakammern 1 und 2, die zusammen die Plasmakammer der ECR-Plasmaquelle bilden und in einer nicht dargestellten Vakuumkammer angeordnet sind.

Die Teil-Plasmakammern 1 und 2 sind rohrförmig ausgebildet und im Inneren sind koaxial je ein einzelner Wellenverteiler 3 und 4 angeordnet. Die Wellenverteiler 3 und 4 entsprechen bekannten Lösungen und bestehen aus einem Innenleiter, der mit einer Einrichtung zur Erzeugung von Mikrowellen, vorzugsweise im Bereich zwischen 910 MHz bis 2,45 GHz, verbunden werden kann. Die Wellenverteiler 3 und 4 sind von Schutzrohren aus Quarzglas umgeben. Der Innenraum der Schutzrohre kann mit einem Gas gespült und damit die Wellenverteiler 3 und 4 gekühlt werden.

Die Wandungen der Teil-Plasmakammern 1 und 2 wirken für die Mikrowellen als äußere Koaxial-Wellenleiter und weisen in bekannter Art vorzugsweise innere Schutzauskleidungen aus dielektrischen oder leitenden Materialien auf. Jeweils zu ihrer Längsachse sind an den rohrförmigen Teil-Plasmakammern 1 und 2 je eine lineare Teil-Plasmaaustrittsöffnung 5 und 6 vorhanden. Dabei sind die radialen Linien 7 und 8 zwischen jeweils dem einzelnen Wellenverteiler 3 und 4 und der Breitenmitte der Teil-Plasmaaustrittsöffnung 5 und 6 zueinander um einen Winkel von 90 Grad geneigt angeordnet. Der Schnittpunkt der radialen Linien 7 und 8 liegt etwa in der Mitte der Plasmaaustrittsöffnung 9 der ECR-Plasmaquelle.

Im Bereich der Teil-Plasmaaustrittsöffnungen 5 und 6 sind außerhalb an den Teil-Plasmakammern 1 und 2 je eine Multipol-Magnetfeldanordnung 10 und 11 mit beispielsweise statischen Magnetfeldern angeordnet.

Weitere Multipol-Magnetfeldanordnungen 12 sind außen am Umfang der Teil-Plasmakammern 1 und 2 angeordnet.

Alle Multipol-Magnetfeldanordnungen 10, 11 und 12 sind derart an den Teil-Plasmakammern 1 und 2 befestigt, dass ihre Lage und damit die Wirkung der Magnetfeldlinien leicht verändert und an konkrete technologische Erfordernisse angepasst werden kann.

Nachfolgend wird die ECR-Plasmaquelle nach Ausführungsbeispiel I in Funktion näher beschrieben. Die ECR-Plasmaquelle befindet sich in einer Vakuumkammer, in der zum Betrieb der ECR-Plasmaquelle ein Druck eines Trägergases, z.B. Argon, von 2x10⁻² mbar eingestellt wird. Die beiden Wellenverteiler 3 und 4 werden an eine Einrichtung zur Erzeugung von Mikrowellen mit beispielsweise 915 MHz angeschlossen. Die beiden Wellenverteiler 3 und 4 wirken als Mikrowellen-Antenne und speisen die Mikrowellen in die Teil-Plasmakammern 1 und 2 ein, wodurch sich in diesen ein Plasma ausbildet. Im Bereich der Multipol-Magnetfeldanordnungen 10 und 11 wirken die Magnetfeldkomponenten auf das Plasma ein, wodurch das aus der Plasmaaustrittsöffnung 9 der ECR-Plasmaquelle austretende Plasma wesentlich verstärkt wird. In entsprechender Weise wirken auch die Magnetfeldkomponenten der Multipol-Magnetfeldanordnungen 12 auf das Plasma.

Die Multipol-Magnetfeldanordnungen 10, 11 und 12 werden durch Positionierung derart an den Teil-Plasmakammern 1 und 2 angeordnet, dass deren Magnetfeldkomponenten entsprechend dem konkreten technologischen Erfordernis eine homogene Plasmaausdehnung zur Plasmaaustrittsöffnung 9 der ECR-Plasmaquelle sowohl in der Länge wie in der Breite mit großer Homogenität bewirkt wird. Damit kann eine Plasmabehandlung eines nicht dargestellten Substrates, welches vor der Plasmaaustrittsöffnung 9 positioniert oder vorbei geführt wird, mit hoher Wirkung und maximaler Qualität gewährleistet werden.

### Ausführungsbeispiel II

Zugehörig zu Aufführungsbeispiel II ist in Figur 2 schematisch eine ECR-Plasmaquelle mit zwei Plasmaaustrittsöffnungen 27 und 28 dargestellt. Die mit dem Ausführungsbeispiel I identischen Positionen sind in Figur 2 mit gleicher Positionsnummer gekennzeichnet.

Zwei langgestreckte U-förmige Teil-Plasmakammern 21 und 22 mit je einem Wellenverteiler 3 und 4, die im Inneren konzentrisch zu den Rundungen der U-förmigen Teil-Plasmakammern 21 und 22 angeordnet sind, weisen in der Breite des inneren Durchmessers Teil-Plasmaaustrittsöffnungen 23 und 24 auf. Dabei liegen die radialen Linien 25 und 26 zwischen jeweils dem einzelnen Wellenverteiler 3 und 4 und der Breitenmitte der Teil-Plasmaaustrittsöffnungen 23 und 24 auf einer Achse.

Der Abstand der Teil-Plasmaaustrittsöffnungen 23 und 24 zueinander ist derart gewählt, dass rechtwinklig und beidseitig zu den radialen Linien 25 und 26 zwei entgegengesetzt wirkende linienartige Plasmaaustrittsöffnungen 27 und 28 gebildet werden. Ähnlich wie beim Ausführungsbeispiel I sind zur Beeinflussung der Ausbildung des Plasmas an der Plasmaaustrittsöffnungen 27 und 28 Multipol-Magnetfeldanordnungen 10 und 11 sowie an den Teil-Plasmakammern 21 und 22 Multipol-Magnetfeldanordnungen 29 angeordnet.

Die Funktion der ECR-Plasmaquelle nach Ausführungsbeispiel II ist ähnlich dem Ausführungsbeispiel I. Bei der Anwendung können die Substrate jedoch beidseitig vor den Plasmaaustrittsöffnungen 27 und 28 angeordnet werden.

### Ausführungsbeispiel III

Zugehörig zu Aufführungsbeispiel III ist in Figur 3 schematisch eine ECR-Plasmaquelle mit einer Plasmaaustrittsöffnung 18 dargestellt. Die mit dem Ausführungsbeispiel I identischen Positionen sind in Figur 3 mit gleicher Positionsnummer gekennzeichnet.

Zwei langgestreckte U-förmige Teil-Plasmakammern 13 und 14 mit je einem Wellenverteiler 3 und 4, die im Inneren konzentrisch zu den Rundungen der U-förmigen Teil-Plasmakammern 13 und 14 angeordnet sind, weisen in der Breite des inneren Durchmessers je eine Teil-Plasmaaustrittsöffnung 17 auf. Dabei liegen die radialen Linien 19 und 20 zwischen jeweils dem einzelnen Wellenverteiler 3 und 4 und der Breitenmitte der Teil-Plasmaaustrittsöffnungen 17 zueinander parallel und bilden die Plasmaaustrittsöffnung 18 der ECR-Plasmaquelle.

Dabei weisen die U-förmigen Teil-Plasmakammern 13 und 14 an den außen liegenden Seiten der Teil-Plasmaaustrittsöffnungen 17 je eine nach außen abgewinkelte Verlängerung 16 auf, deren Länge und Form von den gegebenen technologischen Bedingungen abhängig ist.

Der Abstand der beiden Teil-Plasmaaustrittsöffnungen 17 zueinander ist derart gewählt, dass die homogenen Einzelplasmen an den Teil-Plasmaaustrittsöffnungen 17 sich weitgehend zu einem homogenen Plasma an der Plasmaaustrittsöffnung 18 der ECR-Plasmaquelle vereinigen.

Ähnlich wie beim Ausführungsbeispiel I sind an den äußeren Seiten der Teil-Plasmaaustrittsöffnungen 17 Multipol-Magnetfeldanordnungen 10 und 11 vorgesehen sowie an den Teil-Plasmakammern 13 und 14 weitere Multipol-Magnetfeldanordnungen 12. Im Ausführungsbeispiel III wurde entsprechend Anspruch 5 zwischen den Teil-Plasmaaustrittsöffnungen 17 eine Multipol-Magnetfeldanordnung 15 vorzusehen, die beidseitig auf die Einzelplasmen an den Teil-Plasmaaustrittsöffnungen 17 einwirkt. Mit dieser Ausbildung kann die Homogenität des Plasmas an der Plasmaaustrittsöffnung 18 der ECR-Plasmaquelle in vorteilhafter Weise beeinflusst werden.

Die Funktion der ECR-Plasmaquelle nach Ausführungsbeispiel III ist ähnlich dem Ausführungsbeispiel I.

### Ausführungsbeispiel IV

Zugehörig zu Aufführungsbeispiel IV zeigt Figur 4a einen Schnitt durch eine konstruktive Ausbildung einer ECR-Plasmaquelle ähnlich Ausführungsbeispiel II. Figur 4b zeigt die ECR-Plasmaquelle in einer perspektivischen Ansicht.

Das Aufführungsbeispiel IV baut auf dem Prinzip des Aufführungsbeispiels II auf, d.h. die Linien 25 und 26 liegen auf einer Achse. Der wesentliche Unterschied besteht darin, dass die ECR-Plasmaquelle nur eine Plasmaaustrittsöffnung 30 aufweist, während die gegenüberliegende Seite mit einem Metallblech 31 abgedeckt ist.

Bei der konkreten Ausführung beträgt der Abstand der beiden Wellenverteiler 3 und 4 zueinander 300 mm. Die Wellenverteiler 3 und 4, bestehend aus einem Innenrohr mit einem Durchmesser von 8 mm und einem Schutzrohr mit einem Durchmesser von 30 mm, sind innerhalb von U-förmigen Teil-Plasmakammern 32 und 33 angeordnet, wobei die U-Form aus einem einseitig offenen Vierkant-Rohr mit abgerundeten Ecken gebildet wird. Die innere Weite dieses Vierkant-Rohres beträgt 110 mm, d.h. der Abstand zwischen Schutzrohr und innerer Wandung der Teil-Plasmakammern 32 und 33 beträgt 40 mm. Die Plasmaaustrittsöffnung 30 der ECR-Plasmaquelle beträgt 200 mm. Zwischen den Teil-Plasmaaustrittsöffnungen 34 und 35 und der Plasmaaustrittsöffnung 30 sind Leitbleche 36 und 37 vorgesehen.

Beidseitig der Teil-Plasmaaustrittsöffnungen 34 und 35 sind paarweise unmittelbar an den Teil-Plasmaaustrittsöffnungen 34 und 35 Multipol-Magnetanordnung 38 und 39 angeordnet. Diese sind wassergekühlt, wodurch auch hohe Umgebungstemperaturen nicht zur Veränderung der Magnetfelddichte führen können.

An den Seiten der Teil-Plasmakammern 32 und 33, die den Teil-Plasmaaustrittsöffnungen 34 und 35 abgewandt sind, befinden sich lineare Gasduschen 41 und beidseitig der Teil-Plasmaaustrittsöffnungen 34 und 35 befinden sich lineare Gasduschen 42 zur Einleitung von Trägergasen oder Prozessgasen.

Die Magnetfelder der Multipol-Magnetanordnung 38 und 39 wurde so eingestellt, dass bevorzugt im Bereich der Wellenverteiler 3 und 4 das ECR-Plasma ausgebildet wird.

In der Nähe der Anschlusspunkte 40 zur Einkopplung der Mikrowellen (Fig. 4b) wurde das Magnetfeld derart abgeschwächt, dass das ECR-Plasma in Richtung zu den Teil-Plasmaaustrittsöffnungen 34 und 35 verschoben wird. Dadurch wird der Plasmadichtegradient der sich durch den erhöhten Leistungsverbrauch in der Nähe der Anschlusspunkte 40 ergibt, durch einen geringeren Magnetfeldeinfluss auf die Plasmaerzeugung unmittelbar an den Wellenverteilern 3 und 4 kompensiert. Diese Anordnung ergibt entlang der Teil-Plasmaaustrittsöffnungen 34 und 35 ein homogenes Plasma, welches schließlich den Mittenbereich der ECR-Plasmaquelle mit Ladungsträgern überflutet. Diese Überlagerung führt auch an der Plasmaaustrittsöffnung 30 der ECR-Plasmaquelle zu einem homogenen Plasmabereich bestimmter Plasmadichte.

Die ECR-Plasmaquelle ist gegenüber der Umgebung vakuumdicht hängend in einer Vakuumkammer angeordnet. Die Vakuumkammer hat eine Länge von 1000 mm und die Länge der aktiven Plasmazone beträgt etwa 950 mm.

Die über die Wellenverteiler 3 und 4 in die ECR-Plasmaquelle eingespeisten Mikrowellen haben eine Frequenz von 2,45 GHz. Jeder der Wellenverteiler 3 und 4 ist an einem Mikrowellen-Generator angeschlossen, der eine Leistung von 2 kW erzeugen kann.

In einer Weiterbildung der Einrichtung nach Ausführungsbeispiel kann im Bereich der Plasmaaustrittsöffnung 30 au-βerhalb der ECR-Plasmaquelle auch ein in der Zeichnung nicht dargestelltes Gittersystem angeordnet sein. Dadurch kann die ECR-Plasmaquell auch als Ionenstrahlquelle eingesetzt werden. Bei einer derartigen Ausbildung werden bevorzugt Multipol-Magnetanordnungen mit Elektrospulenanordnungen verwendet.

Bei einer Anwendung der erfindungsgemäßen ECR-Quelle wurden zu bearbeitende Substrate kontinuierlich an der Plasmaaustrittsöffnung 30 vorbei bewegt. Entsprechend deren großer Breite können auch große Substratflächen mit einem homogenen Plasma behandelt werden.

Bei der Abscheidung einer Siliziumnitridschicht auf Siliziumscheiben der Abmessungen 125 mm x 125 mm befanden sich gleichzeitig 30 derartige Siliziumscheiben in einem Raster von 5 Zeilen mal 6 Spalten auf einer Trägerplatte. Die 6 Spalten waren dabei in Achsenrichtung der Plasmaaustrittsöffnung 30 angeordnet und die Trägerplatte in der Ausdehnung der 5 Zeilen wurde kontinuierlich unterhalb Plasmaaustrittsöffnung 30 vorbei bewegt.

Zur Erzeugung der Siliziumnitridschichten wurde über die Gasduschen 41 Ammoniakgas eingelassen und über die Gasduschen 42 das Gas Silan. Mittels einer nicht in der Zeichnung dargestellten Strahlungsheizung wurden die Siliziumscheiben auf eine definierte Temperatur aufgeheizt.

In Abstimmung mit der technologisch vorgegebenen Dicke der abzuscheidenden Siliziumnitridschichten von ca. 80 nm wurde die Geschwindigkeit der Trägerplatte so eingestellt, das die geforderte Schichtdicke bei einem Bewegungszyklus erreicht wurde.

Die Schichtdicken der Siliziumnitridschichten wiesen bei einer Beschichtungsbreite von ca. 800 mm Inhomogenitäten von weniger ± 2% auf. Vorteilhaft war dabei, dass in der Folge der relativ homogenen Schichtdicke auch der Brechungsindex der Siliziumnitridschichten über die große Beschichtungsbreite von 800 mm in einem Toleranzfeld von weniger ± 1% lag.

## Patentansprüche

1. ECR-Plasmaquelle mit einer linearen Plasmaaustrittsöffnung (9, 27, 28, 30), bestehend aus einer Plasmakammer, in der ein zentrischer Wellenverteiler vorhanden ist, welcher mit einer Einrichtung zur Erzeugung einer Hochfrequenz verbunden ist und der gleichzeitig als Außenleiter wirkt, sowie mit einer Multipol-Magnetfeldanordnung im Bereich der linearen Plasmaaustrittsöffnung, **dadurch gekennzeichnet, dass**
- als zentrischer Wellenverteiler mindestens zwei einzelne Wellenverteiler (3, 4) vorhanden sind,
- die innerhalb je einer Teil-Plasmakammer (1, 2, 21, 22, 32, 23) angeordnet sind,
- wobei die Teil-Plasmakammern (1, 2, 21, 22, 32, 33) innerhalb der Plasmakammer derart ausgebildet sind, dass sie die einzelnen Wellenverteiler (3, 4) im Wesentlichen koaxial umschließen und je eine lineare Teil-Plasmaaustrittsöffnung (7, 8, 23, 24, 34, 35) vorhanden ist,
- dass an jeder linearen Teil-Plasmaaustrittsöffnung (7, 8, 23, 24, 34, 35) eine Multipol-Magnetfeldanordnung (10, 11, 38, 39) vorhanden ist
- und dass die mindestens zwei linearen Teil-Plasmaaustrittsöffnungen (7, 8, 23, 24, 34, 35) derart zueinander angeordnet sind, dass sie zusammen mindestens eine Plasmaaustrittsöffnung (9, 27, 28, 30) der ECR-Plasmaquelle bilden.

2. ECR-Plasmaquelle nach Anspruch 1, **dadurch gekennzeichnet, dass** die beiden radialen Linien (7, 8) zwischen jeweils dem einzelnen Wellenverteiler (3, 4) und der Breitenmitte der Teil-Plasmaaustrittsöffnung (6, 7) winklig zueinander angeordnet sind, derart, dass sie sich etwa in der Mitte der Plasmaaustrittsöffnung (9) der ECR-Plasmaquelle schneiden.

3. ECR-Plasmaquelle nach Anspruch 1, **dadurch gekennzeichnet, dass** die beiden radialen Linien (25, 26) zwischen jeweils dem einzelnen Wellenverteiler (3, 4) und der Breitenmitte der Teil-Plasmaaustrittsöffnung (23, 24, 34, 35) in einer gemeinsamen Achse liegen und mindestens eine Plasmaaustrittsöffnung (28, 27, 30) der ECR-Plasmaquelle seitlich, insbesondere rechtwinklig zur gemeinsamen Achse vorhanden ist.

4. ECR-Plasmaquelle nach Anspruch 1, **dadurch gekennzeichnet, dass** die beiden radialen Linien (19, 20) zwischen jeweils dem einzelnen Wellenverteiler (3, 4) und der Breitenmitte der Teil-Plasmaaustrittsöffnung (17) zueinander parallel angeordnet sind und eine Plasmaaustrittsöffnung (18) der ECR-Plasmaquelle in Richtung der beiden radialen Linien (19, 20) vorhanden ist.

5. ECR-Plasmaquelle nach Anspruch 4, **dadurch gekennzeichnet, dass** als Multipol-Magnetfeldanordnung an den Seiten der linearen Teil-Plasmaaustrittsöffnung (17), die aneinander grenzen, eine Multipol-Magnetfeldanordnung (15) ausgebildet ist, welche auf beide Teil-Plasmaaustrittsöffnung (17) wirkt.

6. ECR-Plasmaquelle nach einem der Ansprüche 1 bis 5, **dadurch gekennzeichnet, dass** axial zur und außerhalb an der Plasmakammer, vorzugsweise axial zu den Teil-Plasmakammern, mindestens eine weitere Multipol-Magnetfeldanordnung (12, 29) vorhanden ist.

7. ECR-Plasmaquelle nach einem der Ansprüche 1 bis 6, **dadurch gekennzeichnet, dass** mindestens eine der Multipol-Magnetfeldanordnungen (10, 11, 12, 29) gegenüber einer Teil-Plasmakammer (1, 2, 21, 22, 32, 33) verschoben werden kann.

8. ECR-Plasmaquelle nach einem der Ansprüche 1 bis 7, **dadurch gekennzeichnet, dass** im Bereich der Plasmaaustrittsöffnung (3) der ECR-Plasmaquelle ein elektrisch leitfähiges Gitter vorhanden ist.

## Claims

1. Electron Cyclotron Resonance (ECR) plasma source having a linear plasma discharge opening (9, 27, 28, 30), comprising a plasma chamber in which a central wave distributor is provided, said wave distributor being connected to a device for generating a radio frequency and simultaneously acting as an outer conductor, and having a multipole magnetic field arrangement in the region of the linear plasma discharge opening, **characterized in that**
- at least two individual wave distributors (3, 4) are provided as the central wave distributor,
- said wave distributors being arranged inside a respective partial plasma chamber (1, 2, 21, 22, 32, 33),
- the partial plasma chambers (1, 2, 21, 22, 32, 33) inside the plasma chamber being formed in such a manner that they surround the individual wave distributors (3, 4) in an essentially coaxial manner, and a respective linear partial plasma discharge opening (7, 8, 23, 24, 34, 35) is provided,
- **in that** a multipole magnetic field arrangement (10, 11, 38, 39) is provided at each linear partial plasma discharge opening (7, 8, 23, 24, 34, 35),
- and **in that** the at least two linear partial plasma discharge openings (7, 8, 23, 24, 34, 35) are arranged with respect to one another in such a manner that they together form at least one plasma discharge opening (9, 27, 28, 30) of the ECR plasma source.

2. ECR plasma source according to Claim 1, **characterized in that** the two radial lines (7, 8) between the respective individual wave distributor (3, 4) and the centre of the width of the partial plasma discharge opening (6, 7) are arranged at an angle to one another in such a manner that they intersect approximately in the centre of the plasma discharge opening (9) of the ECR plasma source.

3. ECR plasma source according to Claim 1, **characterized in that** the two radial lines (25, 26) between the respective individual wave distributor (3, 4) and the centre of the width of the partial plasma discharge opening (23, 24, 34, 35) are located on a common axis, and at least one plasma discharge opening (28, 27, 30) of the ECR plasma source is provided to the side of the common axis, in particular at right angles to the latter.

4. ECR plasma source according to Claim 1, **characterized in that** the two radial lines (19, 20) between the respective individual wave distributor (3, 4) and the centre of the width of the partial plasma discharge opening (17) are arranged parallel to one another, and a plasma discharge opening (18) of the ECR plasma source is provided in the direction of the two radial lines (19, 20).

5. ECR plasma source according to Claim 4, **characterized in that** a multipole magnetic field arrangement (15) which acts on both partial plasma discharge openings (17) is formed as a multipole magnetic field arrangement at those sides of the linear partial plasma discharge opening (17) which adjoin one another.

6. ECR plasma source according to one of Claims 1 to 5, **characterized in that** at least one further multipole magnetic field arrangement (12, 29) is provided axially to the plasma chamber and on the outside of the latter, preferably axially to the partial plasma chambers.

7. ECR plasma source according to one of Claims 1 to 6, **characterized in that** at least one of the multipole magnetic field arrangements (10, 11, 12, 29) can be moved relative to a partial plasma chamber (1, 2, 21, 22, 32, 33).

8. ECR plasma source according to one of Claims 1 to 7, **characterized in that** an electrically conductive grid is provided in the region of the plasma discharge opening (3).

## Revendications

1. Source de plasma ECR dotée d'une ouverture linéaire (9, 27, 28, 30) de sortie du plasma et constituée d'une chambre à plasma qui présente en son centre un répartiteur d'ondes qui est relié à un dispositif de création de hautes fréquences et qui sert en même temps de conducteur extérieur, ainsi que d'un système de champ magnétique multipolaire situé dans la zone de l'ouverture linéaire de sortie du plasma, **caractérisée en ce que** :
- au moins deux répartiteurs d'ondes individuels (3, 4) sont prévus comme répartiteur central d'ondes,
- **en ce que** ces répartiteurs d'ondes sont tous deux disposés dans une partie (1, 2, 21, 22, 32, 33) de la chambre à plasma,
- **en ce que** les parties (1, 2, 21, 22, 32, 33) de la chambre à plasma sont formées à l'intérieur de la chambre à plasma de telle sorte qu'elles entourent essentiellement coaxialement les répartiteurs d'ondes (3, 4) individuels et qu'elles présentent toutes une ouverture linéaire (7, 8, 23, 24, 34, 35) de sortie du plasma hors de la partie,
- **en ce qu'**un système de champ magnétique multipolaire (10, 11, 38, 39) est prévu sur chaque ouverture linéaire (7, 8, 23, 24, 34, 35) de sortie du plasma hors de la partie et
- **en ce que** les deux ouvertures linéaires (7, 8, 23, 24, 34, 35) de sortie du plasma hors de la partie au moins prévues sont disposées l'une par rapport à l'autre de manière à former ensemble au moins une ouverture (9, 27, 28, 30) de sortie de plasma de la source de plasma ECR.

2. Source de plasma ECR selon la revendication 1, **caractérisée en ce que** les deux lignes radiales (7, 8) qui relient les répartiteurs d'ondes (3, 4) individuels et le milieu de la largeur de l'ouverture (6, 7) de sortie du plasma hors de la partie sont disposées obliquement l'une par rapport à l'autre de telle sorte qu'elles se coupent sensiblement au milieu de l'ouverture (9) de sortie du plasma de la source de plasma ECR.

3. Source de plasma ECR selon la revendication 1, **caractérisée en ce que** les deux lignes radiales (25, 26) qui relient les répartiteurs d'ondes (3, 4) individuels et le milieu de la largeur de l'ouverture (23, 24, 34, 35) de sortie du plasma hors de la partie sont situées sur un axe commun et **en ce qu'**au moins une ouverture (28, 27, 30) de sortie du plasma de la source de plasma ECR est disposée sur le côté et en particulier à la perpendiculaire de l'axe commun.

4. Source de plasma ECR selon la revendication 1, **caractérisée en ce que** les deux lignes radiales (19, 20) qui relient les répartiteurs d'ondes (3, 4) individuels et le milieu de la largeur de l'ouverture (17) de sortie de plasma hors de la partie sont disposées parallèlement l'une à l'autre et **en ce qu'**une ouverture (18) de sortie de plasma de la source de plasma ECR est prévue dans la direction des deux lignes radiales (19, 20).

5. Source de plasma ECR selon la revendication 4, **caractérisée en ce que** comme système de champ magnétique multipolaire, un système (15) de champ magnétique multipolaire qui agit sur les deux ouvertures (17) de sortie de plasma hors des parties est formé sur les côtés de l'ouverture linéaire (17) de sortie de plasma hors de la partie, qui sont adjacentes l'une à l'autre.

6. Source de plasma ECR selon l'une des revendications 1 à 5, **caractérisée en ce qu'**au moins un autre système (12, 29) de champ magnétique multipolaire est prévu axialement par rapport à la chambre à plasma et à l'extérieur de celle-ci et de préférence axialement par rapport aux parties de chambre à plasma.

7. Source de plasma ECR selon l'une des revendications 1 à 6, **caractérisée en ce qu'**au moins l'un des systèmes (10, 11, 12, 29) de champ magnétique multipolaire peut être déplacé par rapport à une partie (1, 2, 21, 22, 32, 33) de chambre à plasma.

8. Source de plasma ECR selon l'une des revendications 1 à 7, **caractérisée en ce qu'**une grille électriquement conductrice est prévue dans la zone de l'ouverture (3) de sortie du plasma de la source de plasma ECR.
